# EUROPÄISCHE PATENTANMELDUNG

(11) **EP 1 005 259 A2**
(43) Veröffentlichungstag der Anmeldung: **31.05.2000**
(21) Anmeldenummer: 99123344.6
(22) Anmeldetag: 23.11.1999
(51) Int. Cl.: H05K 1/02

(54) **Leiterplatte**

(30) Priorität: 25.11.1998 DE 19854271
(71) Anmelder: ILFA Industrieelektronik und Leiterplattenfertigung aller Art GmbH, 30559 Hannover (DE)
(72) Erfinder: Dirks, Christian, 78166 Donaueschingen (DE)
(74) Vertreter: Patentanwälte Thömen & Körner

(57) **Zusammenfassung**

Es wird eine Leiterplatte beschrieben.

Die Leiterplatte besitzt wenigstens eine elektrisch leitende Fläche, die metallisches Material umfaßt. Die Fläche weist einen mittleren Gesamtwiderstand auf, der erheblich höher ist als der ohmsche Widerstand einer gleich großen einteiligen Fläche aus demselben metallischen Material.

## Beschreibung

Es sind Leiterplatten bekannt, die flächige Stromversorgungssysteme enthalten. Sie bestehen aus durchgehenden metallischen Leiterflächen, die Löcher und kleinere Aussparungen enthalten können oder aus metallischen Leiterbahnen. Als Materialien für die Leiterflächen oder Leiterbahnen dient Kupfer. Wenigstens eine dieser Flächen oder Bahnen führt Versorgungsspannung, wenigstens eine andere dieser Lagen führt Massepotential. Außerdem werden in mehrlagigen Leiterplatten Masseflächen verwendet, die lediglich als Bezugsmasse für Leiterbahnen dienen, aber nicht direkt Massepotential führen.

Störleistung kann sich auf diesen Flächen oder Bahnen ausbreiten und in angrenzende Bauelemente einstrahlen oder in die Umgebung abstrahlen. Es ist zwar bekannt, zwischen Anschlüssen für Quellen der Störleistung und Bezugspotential Kondensatoren zu schalten, die Störleistung verschwindet aber dadurch in keinem Fall, sondern wird lediglich reflektiert.

Man kann Störleistung also nicht dadurch vernichten, daß man sie zur Masse ableitet.

Der Erfindung liegt die Aufgabe zugrunde, eine Leiterplatte dahingehend zu verbessern, daß die Ausbreitung und/oder Abstrahlung von Störleistung verringert wird.

Diese Aufgabe wird bei einer Leiterplatte mit den Merkmalen des Anspruchs 1 gelöst.

Weiterbildungen und vorteilhafte Ausgestaltungen ergeben sich aus den Unteransprüchen und der weiteren Beschreibung.

Die erfindungsgemäße Leiterplatte enthält zumindest eine elektrisch leitende Fläche oder elektrisch leitende Bahn, deren mittlerer Gesamtwiderstand erheblich höher ist, als der ohmsche Widerstand üblicher durchgehender oder vollflächiger metallischer Leitermaterialien, wie Kupfer, Silber, Gold, Aluminium oder Eisen. Auch bei der erfindungsgemäßen Leiterplatte bestehen die elektrisch leitenden Flächen oder Bahnen grundsätzlich aus Metall, z. B. aus Kupferfolie, wie dies bei den bisher bekannten Flachen oder Bahnen auch der Fall ist. Diese Flächen oder Bahnen sind aber bei einer praktischen Ausgestaltung der erfindungsgemäßen Konstruktion unterbrochen und die Unterbrechungen mit einem elektrisch wesentlich schlechter leitenden Material überbrückt. Hierdurch werden die Stromwärmeverluste in der absorptiven Fläche wesentlich höher, als in einer konventionellen Kupferfläche.

Die Erfindung beruht auf der Erkenntnis, daß es nicht ausreicht, lediglich ein schlechter leitendes metallisches Material, wie Eisen oder Konstantan zu verwenden. Gerade bei hochfrequenten Störungen, auf deren Beseitigung die vorliegende Erfindung abzielt, spielt der Skin-Effekt eine wesentliche Rolle. Es zeigt sich nämlich, daß bei hochfrequenten Strömen die Eindringtiefe in das Material und damit der leitende Querschnitt mit zunehmendem spezifischem Widerstand zunimmt. Der bei hochfrequenten Strömen in widerstandsbehafteten Materialien wirksame Widerstand wird also durch den Skin-Effekt in unerwünschter Weise teilweise kompensiert. Dadurch sind die Unterschiede in der Leitfähigkeit geringer, als die Unterschiede der spezifischen Leitfähigkeit der betreffenden Materialien für Gleichstrom erwarten lassen. Durch ein wesentlich schlechter leitendes Material in einem begrenzten Abstand zwischen zwei gut leitenden Flächen oder Bahnen gelingt es, hochfrequenten Strömen einen deutlich höheren elektrischen Widerstand zu bieten.

Gemäß einer Weiterbildung weisen die Segmente einen Durchmesser von 2 bis 10 mm auf. Die Größe dieser Segmente soll sicherstellen, daß dort nur eine geringe Ladung gespeichert werden kann, damit bei Stromspitzen der Strom über die widerstandsbehafteten Zwischenräume aus benachbarten Segmenten fließen muß.

Vorzugsweise sind die Segmente sechseckig ausgebildet. Dadurch läßt sich eine gute Anbindung an benachbarte Segmente in Längsrichtung, Querrichtung und Diagonalrichtung erzielen.

Die Spalte zwischen den Segmenten sind vorzugsweise 0,1 bis 2 mm breit. Dies ermöglicht es, ausreichend Widerstandsmaterial in die Spalte einzubringen aber auch die Dichte der Segmente so aufrecht zu erhalten, das genügend enge lötbare Stützpunkte für Anschlüsse vorhanden sind.

Zweckmäßig bildeten die Spalte ein zusammenhängendes Netz gleichmäßige Struktur. Auf diese Weise entsteht ein Raster, das der Leiterplatte gleichmäßig verteilte elektrische Eigenschaften verleiht und außerdem die Anordnung der integrierten Schaltungen vereinfacht.

Auf einer oder beiden Seiten der Kupferfolie kann eine Schicht aus Widerstandsmaterial, wie Karbonpaste aufgebracht. Hierdurch werden die Unterbrechungen zwischen den Strukturelementen mit Widerstandsmaterial vollständig aufgefüllt, so daß wieder eine elektrisch leitende Gesamtfläche entsteht. Durch die Verwendung von Karbonpaste kann sich das Widerstandsmaterial Zwischenräumen einer beliebigen Form anpassen.

Das die Spalte ausfüllende elektrisch leitende Material kann in Dickfilmtechnik oder durch Siebdruck aufgebracht werden. Diese Techniken sind bei der Herstellung von Leiterplatten geläufig, wodurch auch bei der erfindungsgemäßen Realisierung reproduzierbare Erfolge sichergestellt werden.

Besonders vorteilhaft ist es, die unterbrochenen oder segmentierten leitenden Flächen oder Bahnen bei Stromversorgungssystemen einzusetzen. Die absorptiven Flächen können dann Störleistung, die durch unregelmäßige Stromaufnahme von integrierten Schaltungen in dieses Flächensystem eingebracht wird, weitgehend absorbieren, wodurch die Abstrahlung aus dem Flächensystem deutlich vermindert wird.

Diese Maßnahme ist besonders bei der Anwendung von CMOS-integrierten Schaltungen wirksam, bei denen Störleistung durch Querströme verursacht wird. Derartige Querströme werden in der Endstufe der integrierten Schaltung gezogen, wenn das Potential des Ausgangs von einem logischen Zustand in den anderen logischen Zustand wechselt. Das Maximum des Querstroms tritt auf, wenn die Flanke des Zustandswechsels ihre größte Steilheit aufweist. Die Dauer eines solchen Querstrom-Piks kann zwischen 1 und 100 ns liegen.

Führt man Signalleitungen über die erfindungsgemäßen absorptiven Flächen, wobei die Fläche jeweils als Rückleiter dient, so klingen reflektierte Leistungen in den Leitungssystemen schneller ab, als dies bei Kupferflächen möglich ist. Hierdurch wird sowohl die Abstrahlung aus dem Leitungssystem verringert, als auch die Signalintegrität besser gewahrt. Das Nebensprechen zwischen den Signalleitungen kann bei richtiger Konstruktion der absorptiven Flächen in vertretbarem Rahmen gehalten werden.

Eine weitere Verbesserung kann erzielt werden, wenn die unterbrochene Leiterfläche oder Leiterbahn zwischen durchgehenden Leiterflächen oder Leiterbahnen angeordnet ist. Es können dadurch spezifische Abstrahlungsprobleme vermindert werden, die teilweise durch die Segmentierung selbst verursacht werden. Dabei handelt es sich um eine E-Feld-Abstrahlung aus der unterbrochenen oder segmentierten Fläche. Diese Abstrahlung wird durch die umgebenden durchgehenden Flächen abgeschirmt.

Bei einer bevorzugten Ausgestaltung sind die Isolierschichten zwischen der unterbrochenen Leiterfläche oder Leiterbahnen einerseits und den durchgehenden Leiterflächen oder Leiterbahnen andererseits so bemessen, daß der Abstand zwischen der unterbrochenen Leiterfläche oder Leiterbahn und der jeweiligen durchgehenden Leiterfläche oder Leiterbahn zwischen 10 und 100 µm, vorzugsweise 50 µm beträgt. Das Leitersystem erhält dadurch einen außerordentlich niedrigen Wellenwiderstand, wodurch im Zusammenhang mit den Verlusten im Leitungssystem Strukturresonanzeffekte vermieden werden. Ferner führt die Dämpfung im Leitungssystem zur Verminderung von Überschwingern auf den Signalpulsen. Dagegen wird die Flankengeschwindigkeit kaum beeinflußt. Dies ist besonders bei Anwendung schneller Logik interessant, weil EMV-Maßnahmen normalerweise eine deutliche Verlangsamung der Flanken bewirken. Die mit den erfindungsgemäßen Maßnahmen erreichbare Dämpfung der Abstrahlung liegt etwa im Bereich von 10 dB.

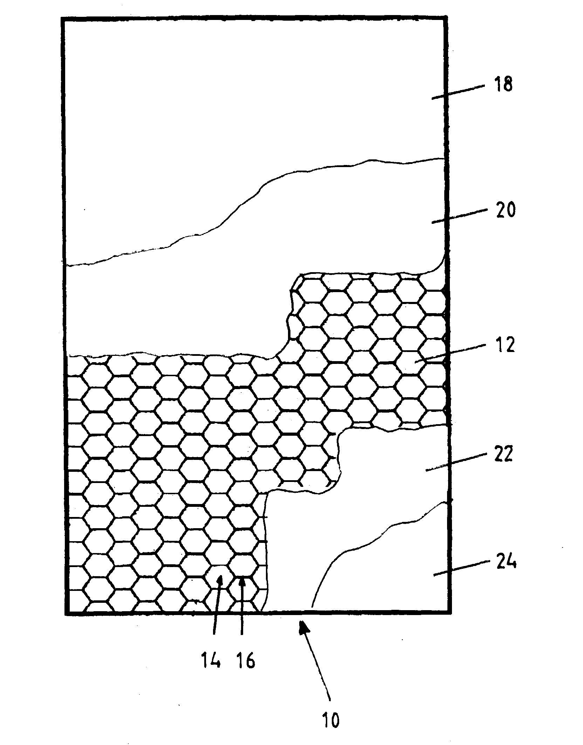

Nachfolgend wird ein Ausführungsbeispiel der Erfindung anhand der Zeichnung erläutert.

Die Zeichnung zeigt in mehreren freigelegten Ebenen eine Leiterplatte in einer erfindungsgemäßen Ausgestaltung.

Eine Leiterplatte 10 ist beispielhaft aus drei leitfähigen Flächen 12, 18 und 24 aufgebaut. Diese Flächen 12, 18 und 24 dienen der Stromversorgung von integrierten Schaltungen. Die zwei äußeren Flächen 18 und 24 führen Bezugspotential oder Massepotential GND, während die mittlere Fläche 12 Betriebsspannungspotential Vcc führt. Zwischen der mittleren Fläche 12 und den beiden äußeren Flächen 18 und 24 sind dünne Isolierschichten 20 und 22 angeordnet.

Die mittlere Fläche 12 besteht aus sechseckigen Segmenten 14 aus Kupfer, die zueinander einen Abstand aufweisen. Ein Zwischenraum 16 zwischen den Segmenten 14 ist mit einer leitfähigen Paste ausgefüllt, die jedoch eine wesentlich schlechtere Leitfähigkeit als Kupfer besitzt. Es handelt sich um Karbonpaste. Demgegenüber sind die Flächen 18 und 24 durchgehend. Sie bestehen ebenfalls aus Kupfer.

Integrierte Schaltungen, mit denen die Leiterplatte 10 bestückt ist, werden mit ihrem Betriebsspannungsanschluß an die mittlere Fläche 12 und mit ihrem Bezugsanschluß an die äußeren Flächen 18 und 24 angeschlossen.

Querströme, die die integrierten Schaltungen bei Wechsel des Ausgangspotentials ziehen, fließen zwangsläufig über die Zwischenräume 16 mit dem widerstandsbehafteten Material. Störleistung wird hierbei von dem widerstandsbehafteten Material teilweise absorbiert. Elektrische Felder, die aufgrund des Spannungsabfalls an diesen Zwischenräumen entstehen, werden durch die benachbarten äußeren Flächen 18 und 24 abgeschirmt. Insgesamt bildet das Leitungssystem einen außerordentlich niedrigen Wellenwiderstand, der wegen des Widerstandes in den Zwischenräumen 16 hochfrequenten Störanteilen eine sehr hohe Dämpfung aufgelegt.

## Patentansprüche

1. Leiterplatte (10) mit wenigstens einer elektrisch leitenden Fläche (12) oder Bahn, die metallisches Material umfaßt, **dadurch gekennzeichnet**, daß die Fläche (12) oder Bahn einen mittleren Gesamtwiderstand aufweist, der erheblich höher ist als der ohmsche Widerstand einer gleich großen einteiligen Fläche oder Bahn aus demselben metallischen Material.

2. Leiterplatte nach Anspruch 1, **dadurch gekennzeichnet**, daß die metallisches Material umfassende Fläche (12) oder Bahn in eine Vielzahl Segmente (14) unterteilt ist, die durch schmale Spalte (16) gegenseitig voneinander getrennt sind, und daß die Spalte (16) mit einem elektrisch leitenden Material ausgefüllt sind, dessen spezifischer ohmscher Widerstand wesentlich höher als der des metallischen Materials ist.

3. Leiterplatte nach Anspruch 2, **dadurch gekennzeichnet**, daß die Segmente (14) einen Durchmesser von 2 bis 10 mm aufweisen.

4. Leiterplatte nach nach Anspruch 2, **dadurch gekennzeichnet**, daß die Segmente (14) sechseckig sind.

5. Leiterplatte nach einem der Ansprüche 2 bis 4, **dadurch gekennzeichnet**, daß die Spalte (16) zwischen den Segmenten (14) zwischen 0,1 und 2 mm breit sind.

6. Leiterplatte nach einem der Ansprüche 2 bis 5, **dadurch gekennzeichnet**, daß die Spalte (16) ein zusammenhängendes Netz gleichmäßiger Struktur bilden.

7. Leiterplatte nach einem der Ansprüche 2 bis 6, **dadurch gekennzeichnet**, daß das die Spalte (16) ausfüllende elektrisch leitende Material Karbonpaste ist.

8. Leiterplatte nach einem der Ansprüche 2 bis 7, **dadurch gekennzeichnet**, daß das die Spalte (16) ausfüllende elektrisch leitende Material in Dickfilmtechnik aufgebracht ist.

9. Leiterplatte nach einem der Ansprüche 2 bis 8, **dadurch gekennzeichnet**, daß das die Spalte (16) ausfüllende elektrisch leitende Material durch Siebdruck aufgebracht ist.

10. Leiterplatte nach einem der Ansprüche 2 bis 9, **dadurch gekennzeichnet**, daß die Fläche (12) oder Bahn aus Segmenten (14) zur Stromversorgung dient.

11. Leiterplatte nach einem der Ansprüche 2 bis 10, **dadurch gekennzeichnet**, daß die Fläche (12) oder Bahn aus Segmenten (14) zwischen durchgehenden Leiterflächen (18, 24) oder Leiterbahnen angeordnet ist.

12. Leiterplatte nach Anspruch 11, **dadurch gekennzeichnet**, daß die Isolierschichten zwischen der Fläche (12) oder Bahn aus Segmenten (14) einerseits und den durchgehenden Leiterflächen (18, 24) oder Leiterbahnen andererseits so bemessen ist, daß der Abstand zwischen der Fläche (12) oder Bahn aus Segmenten (14) und der jeweiligen durchgehenden Leiterfläche (18, 24) oder Leiterbahn zwischen 10 und 100 µm, vorzugsweise 50 µm beträgt.
